# EUROPEAN PATENT APPLICATION

(11) **EP 1 376 233 A2**
(43) Date of publication of application: **02.01.2004**
(21) Application number: 03019331.2
(22) Date of filing: 16.02.1999
(51) Int. Cl.: G03F 7/039, C08F 2/50

(54) **Method of producing a resin for a radiation-sensitive material**

(30) Priority: 17.02.1998 JP 5000798
(62) Divisional of application: 99400360.6
(71) Applicant: Daicel Chemical Industries, Ltd., Sakai-shi, Osaka-fu (JP)
(72) Inventor: Miyake, Hiroto, Ohtake-shi Hiroshima-ken (JP)
(74) Representative: Portal, Gérard

(57) **Abstract**

The present invention relates to a radioactive-rays sensitive material which comprises a resin (IA) having in the molecule at least one functional group which is capable of producing an alkali-soluble group under the action of an acid and at least one alicyclic functional group containing a polar group, and/or a resin (IIA) containing in the molecule at least one functional group which is capable of producing an alkali-soluble group under the action of an acid and at least one unsaturated group, and a compound (B) which produces an acid under irradiation with radioactive-rays. The present invention also relates to a method for forming a pattern by using such a material. The invention enables obtaining a stable pattern which is inexpensive and has an excellent transparency and dry-etching resistance, a high sensitivity and moreover an excellent adhesion. The invention also enables the production of submicroscopic semiconductors.

## Description

The present invention relates to a radioactive-rays sensitive material and to a pattern made by using such a material. In more detail, the present invention relates to a radioactive-rays sensitive material which comprises a resin (A) containing at least one functional group which is capable of producing an alkali-soluble group under the action of an acid and at least one alicyclic functional group having a polar group or unsaturated group in the molecule, and a compound (B) which produces an acid when exposed to radioactive-rays. The present invention also concerns a method for forming a pattern made from the above-mentioned radioactive-rays sensitive material by using laser beam.

### Background of the invention

Recently, the integration of semiconductor integrated circuits has made progress, and an LSI and a VLSI have been put to practical use. Simultaneously, the width of the integrated circuit line has a tendency to become microscopic or submicroscopic.

In order to form an integrated circuit, it is necessary to form a microscopic pattern on a thin layer of a semiconductor which is coated on an insulator. The insulator coated with the semiconductor will be called hereinafter "the base plate to be treated". The technical use for this purpose is lithography (photo-etching) and is carried out as follows, First, the surface of the base plate to be treated is covered with a resist, and then light is applied on the resist layer through a determined base pattern (selected irradiation). Then the parts of the semiconductor thin layer which appear after development form a resist pattern layer which is formed by dissolving the resist layer. This resist pattern is used as a mask for carrying out a dry-etching. The desired final pattern is obtained by removing the remaining resist layer.

The light source used for lithography was at first an ultra-violet rays source. However, since the patterns became microscopic, sources such as electronic beams, far ultra-violet rays and X rays or the like having a short wavelength have been used as light sources. Nowadays, more particularly eximer lasers which produce far ultra-violet rays (for example, KrF laser having a wavelength of 248 nm, ArF laser having a wavelength of 193 nm) or a YAG laser with wavelength changing crystals (wavelengths 248nm, 193 nm, 157 nm) or the like are used in lithography techniques. Thus, resists having a high resolution, a high sensitivity and an excellent dry-etching resistance have been needed for such a lithography technique.

It is to be noted that the radioactive rays to be employed for the radioactive-rays sensitive material of the present invention are rays used for forming semiconductor circuits such as the above-mentioned ultra-violet rays, far ultra-violet rays, X rays and particularly a laser beam in the far ultra-violet region.

The resists in the prior art are mainly developed from a base made of a phenol resin or a novolak resin. These compounds contain aromatic rings and have an excellent dry-etching resistance. However, their transparency is low with respect to the wavelength of a KrF laser. In particular, they are non-transparent to the wavelength of ArF laser. Thus, it has not been possible to obtain an accuracy suitable for forming a microscopic pattern.

On the other hand, polymers of t-butyl methacrylate have been proposed as resists which are transparent to the eximer laser beam. However, these resists have a poor dry-etching resistance. For this reason, chemically amplified-type resists using alicyclic compounds, having a dry-etching resistance like the aromatic ring compounds and which are transparent to the KrF laser wavelengths and the ArF laser wavelengths have been disclosed in JP-A-0439665 and JP-A-07234511.

Further, when these chemically amplified-type resists are irradiated, a reaction is caused which produces an acid in the resist material. After irradiation, the resist is heated and the produced acid acts as a catalyst in the pattern-forming reaction which occurs in the resist material. Moreover, the pattern-forming reaction (curing or degradation) occurs several times thus changing the solubility of the irradiated portion of the resist in the developing solution.

Alicyclic copolymers containing alicyclic compounds such as norbornene, perhydroanthracene, cyclohexane, tricyclo[5.2.1.0^{2.6}]decane, adamantane or the like are disclosed as chemically amplified-type resists.

However, when the ratio of alicyclic copolymer which confers to these resists their dry-etching resistance, increases in the chemically-amplified resists comprising the above-mentioned alicyclic copolymer, the hydrophobicity of the polymer also increases and the rigidity also increases at the same time. Consequently, the ratio of the alicyclic compounds to be used to obtain a composition having the same dry-etching resistance as the resists made from a phenol resin base or novolak resin base becomes too great. For example, when the unit structure exceeds 50% by mol in alicyclic groups, the hydrophobicity becomes high and moreover the resist becomes too hard. For this reason, the diffusion of the catalytic protonic acid is prevented and the chemical amplification ratio is lowered, the weight of the carboxylic acid produced in the polymer which is a resist material is reduced and the solubility in the alkali developing solution is lowered.

Further, due to the introduction of alicyclic groups, these resists have a poor adhesion and since the resist layer becomes hard, the deformations in the resist layer become large and the resist layer becomes easy to peel off. Thus, there has been a problem in that a stable resist pattern cannot be obtained.

Moreover, the specific problem of the chemically amplified-type resists is that during heating after being exposed to radiations (PEB), the acid catalyst which is produced by the irradiation is inactivated or neutralized by the impurities (amine components or the like) and it is not possible to form a desired pattern. As an improvement, a pattern forming method is already known in which the resist layer is coated with a protective layer.

This method is very efficient for the resists containing phenol as a base polymer. This is the case of the majority of the resists of the prior art. However, when the resist has, as a base polymer, a non-phenolic polymer which has a low polarity, particularly a resist having hydrophobic base polymer containing alicyclic groups, it is difficult to apply the protective layer thereon. The polarities of the protective layer and the resist are similar and thus solvents such as aromatic hydrocabon-type solvents which are used in prior art as solvents for the protective layer cannot be used because they dissolve the resist layer itself. For this reason, due to the influence of impurities, the pattern cannot be defined or the size of the pattern is far from the desired size.

In order to solve the above-mentioned issue, JP-A-07234511 discloses a radioactive-rays sensitive material having excellent transparency and dry-etching resistance and moreover an excellent adhesion and a high sensitivity which is used in lithography using an eximer laser as an irradiation source.

However, there are some drawbacks in that when the dry-etching resistance is sufficient, the developability is weakened and at the same time the adhesion is not sufficient.

Moreover, in order to confer a dry-etching resistance to the resists having a phenol resin or a novolak resin as a base, it is necessary that the unit structure contains not less than 50% mol of alicyclic groups. However, these compounds containing alicyclic groups are very expensive and it is actually impossible to introduce not less than 50% by mol in a resin.

### Summary of the invention

The first aim of the present invention is to provide a radioactive-rays sensitive material which enables the production of submicroscopic semiconductors and which is transparent to the radioactive rays used for forming patterns and particularly to far ultra-violet laser beam, and which has an excellent developability, a dry-etching resistance and moreover excellent adhesion and sensitivity.

The second aim of the present invention is to provide a method for forming a pattern which is inexpensive by using a radioactive-rays sensitive material which has not only excellent transparency and dry-etching resistance but also has a high sensitivity and moreover an excellent adhesion.

The inventors of the present invention found the radioactive-rays sensitive material of the invention as a result of an intensive research to improve the adhesion of a radioactive-rays sensitive material. The radioactive-rays sensitive material of the invention represents a solution to the above-mentioned problems.

The radioactive-rays sensitive material of the invention is produced from a resin (A) comprising, per molecule, at least one functional group which is capable of producing an alkali-soluble group under the action of an acid and one alicyclic functional group having a polar group or an unsaturated group, and from a compound (B) which produces an acid when exposed to radioactive-rays.

Thus a radioactive-rays sensitive material which has an excellent dry-etching resistance and which is obtained by a combination of radical crosslinking with lithography of a chemically amplified-type resist via eximer laser, has been sucessfully obtained.

The first aspect of the invention provides for the first time a radioactive-rays sensitive material which comprises a resin (IA) having in the molecule at least one functional group which is capable of producing an alkali-soluble group under the action of an acid and at least one alicyclic functional containing a polar group, and/or a resin (IIA) containing in the molecule at least one functional group which is capable of producing an alkali-soluble group under the action of an acid and at least one unsaturated group, and a compound (B) which produces an acid under irradiation with radioactive-rays.

The second aspect of the present invention also provides a radioactive-rays sensitive material containing a functional group which is capable of producing an alkali-soluble group under the action of an acid, as of Formula (1) or (2).

- COOR₁ (1)

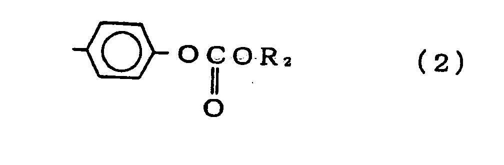

wherein R₁ and R₂ are independently selected from -C(CH₃)₂R₃, -Si(CH₃)₂R₃ with R₃ being an alkyl group having 1-20 carbons or an aromatic group having 6-14 carbons, or

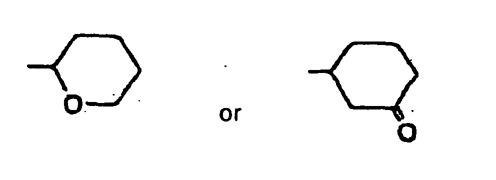

The third aspect of the present invention also provides a radioactive-rays sensitive material obtained from a resin (IA) and a resin (IIA) which are both acrylic resins.

The fourth aspect of the present invention provides a radioactive-rays sensitive material characterised in that the polar group of resin (IA) is a hydroxyl group.

The fifth aspect of the invention provides that the alicyclic functional group containing a hydroxyl group in the resin (IA) is an adamantyl group having at least one hydroxyl group.

The sixth aspect of the invention provides that the unsaturated group in said resin (IIa) is a (meth)acryloyl group.

The seventh aspect of the invention provides that the resin (IIA) contains an alicyclic functional group derived from an unsaturated monomer having an epoxy group.

The eighth aspect of the invention provides that the radioactive-rays sensitive material contains said resin (IIA) and further a polymerisation initiator used for crosslinking.

The ninth aspect of the present invention provides a method for forming a pattern wherein the above-mentioned radioactive-sensitive material is coated on a thin layer of semiconductor, then selectively irradiated by a far ultra-violet laser, baked and developed with an alkali solution to remove said radioactive-rays sensitive material.

The tenth aspect of the present invention provides a method for forming a pattern wherein developing is carried out by using a solution which is a mixture of an aqueous solution of an organic alkali compound and isopropyl alcohol.

The elenventh aspect of the invention provides a method for forming a pattern characterised in that the radioactive-rays sensitive material which contains said resin (IIA) is developed with an alkali solution and then crosslinked between molecules using a polymerisation initiator for crosslinking and then submitted to a dry etching.

According to the twelfth aspect of the invention, the aqueous solution of an organic alkali compound is a solution of tetramethylammonium hydroxide.

### Detailed description

The radioactive-rays sensitive material (I) of the present invention comprises a resin (IA) containing in one molecule at least one functional group capable of producing an alkali-soluble group under the action of an acid and at least one alicyclic functional group containing polar groups and/or (IA) and a compound (B) which produces an acid when irradiated with radioactive rays.

The radioactive-rays sensitive material (II) of the present invention comprises a resin (IIA) containing in the molecule at least one unsaturated group and a functional group capable of producing an alkali-soluble group under the action of an acid, and a compound (B) which produces an acid when irradiated with radioactive rays.

In the present invention, the acid catalyst is formed from the compound (B) which is irradiated. The functional groups in the resins (IA) and/or (IIA) which constitute the resist material are decomposed by the acid catalyst and then become soluble in alkali solutions. The resin of the irradiated portion is then dissolved when developing with an alkali developing solution. As a result, the resist is heated after being irradiated, the semiconductor thin layer then forms at the places of the portions which have been dissolved when developing. On the portions which have not been irradiated and thus which are not dissolved, the resist remains and forms a resist pattern. After a plasma treatment for dry-etching, the remaining resist layer is removed and a semiconductor circuit having a desired pattern is obtained.

### [1] First, the resin (IA) which constitutes the radioactive-sensitive material (I) of the present invention and starting materials thereof will now be explained.

### Resin (IA)

The resin (IA) which contains in the molecule at least one unsaturated group and at least one functional group capable of producing an alkali-soluble group under the action of an acid is obtained by copolymerisation of a monomer (C) containing alicyclic functional groups, which contain polar groups, with a monomer (D) which contains functional groups that becomes soluble in an alkali solution under the action of an acid.

### Monomer (C) containing alicyclic functional groups which contain polar groups

Monomer (C) such as, for example, hydroxyadamantyl(meth)acrylate which contains at least one substituent and hydroxynorbonyl(meth)acrylate may be used.

Ketones, alcohols, ethers, esters, carboxylic acids, acid anhydride compounds or these compounds substituted with sulphur, nitrogen or a halogen may be used as highly polar compounds to be introduced into the resin (IA) to obtain a high polar base polymer. The compounds that may be introduced are not limited to these examples. The proportion of these compounds introduced into the resin (IA) is 1-50mol% or so and preferably not less than 20mol%.

Further, as alicyclic functional groups, compounds containing in their structure, as a skeleton, cyclohexane, norbornane, norbornene, perhydro-anthracene, adamantane, tricyclo-[5.2.1.0^{2.6}]-decane may be used, for example. Further, as the alicyclic functional groups containing polar groups, adamantyl groups containing mono-, di-, tetra-hydroxy groups or similar groups may be used, for example. However, the functional groups that may be used are not limited to these groups.

### Monomer (D) which contains a functional group capable of producing an alkali-soluble group by an acid

Monomers having unsaturated bonds and an acid group which is substituted and linked with other groups such as compounds of Formula (1) or (2) may be used as the monomer (D) having a functional group capable of producing an alkali-soluble group by an acid. As acid group, carboxyl groups, phenolic hydroxyl groups, sulphonic acid groups and the like may be given as examples.
Specifically, the following acrylic acids having a substituent group and styrenes may be given as examples.

As the acrylic acids, acrylic acid, methacrylic acid, ethyl acrylic acid, or other acrylic acids substituted with alkyl groups may be used. As the styrenes, para hydroxy-styrene, para carboxy-styrenes or the like may be used. The functional group which is a carboxyl group or a phenol group (in the case of the para hydroxy-styrene) is linked to a substituent. In the case of a phenol group, the substituted group is preferably linked via a carbonate bond.

As the above-mentioned substituted group capable of producing an alkali-soluble group under the action of an acid, groups that may be dissociated by a protonic acid such as t-butyl group, tetra-hydropyranyl group, a, a-dimethylbenzyl group, 3-oxocyclohexyl group or the like, may be used without any limitation.

As the resin (IA), the acrylic copolymers having a (meth)acrylic group as a base selected from the above-mentioned monomers (C) and (D) may be used due to no absorption by far ultra-violet ray (eximer laser beam) and simple synthesis.

Further, a monomer (P) having reactive unsaturated bonds, moreover an additive (Q) of (meth)acrylic acid with e-caprolactone, a modified unsaturated monocarboxylic acid (R), can be employed with the above-mentioned monomers (C) and (D).

The above-mentioned monomer (P) having reactive unsaturated bonds includes hydroxyethyl(meth)acrylate, hydroxypropyl(meth)acrylate, hydroxybutyl(meth)acrylate, polycaprolactonediolmono(meth)acrylate, polyoxyethylene glycol, mono(meth)acrylate or other hydroxyl group-containing monomers ; (meth)acrylic acid, itaconic acid, maleic acid, fumaric acid, crotonic acid, b-carboxyethyl(meth)acrylate or the like.

Further, as the modified unsaturated monocarboxylic acid (R) described below, the same compounds as those used for the resin (IIA) which will be explained below may be used.

Optionally, it is possible to add to the monomer (R) a monomer (T) having an unsaturated group which is radically polymerisable such as methyl(meth)acrylate, ethyl(meth)acrylate, isopropyl(meth)acrylate, n-butyl(meth)acrylate, 2-ethylhexyl(meth)acrylate, acrylonitrile, acrylamide, styrene, vinyl toluene, vinyl acetate, isopropyl vinyl ether, n-butylvinyl ether, methoxyethylvinyl ether or the like.

The above-mentioned monomers (C) and (D), a monomer (P) having reactive unsaturated bonds, moreover the additive (Q) of (meth)acrylic acid with e-caprolactone and the modified unsaturated monocarboxylic acid (R) are thermally polymerised in a solvent in the presence of a polymerisation catalyst.

The molar ratio of the polymer (D) with respect to the polymer (C) is 0.3-100.

The polymerisation catalyst that may be used is, for example, a peroxide-type catalyst, or a diazonium-type catalyst, or other radical initiator, 2, 2, 6, 6-tetramethyl-1-piperidinyloxy (TEMPO), benzoyl peroxide or other radical initiator with which molecular weight distribution can be controlled.

In order to further control the molecular weight distribution, it is possible to polymerise according to an anionic polymerisation using an alkyllithium or the like, a Ziegler Natta catalyst or according to an anionic polymerisation using a rare-earth metal catalyst.

The reaction temperature depends on the reaction type but is about -78-200°C.

The resin (IA) obtained may be optionally purified by re-precipitation.

Regarding the polymers obtained from a material having a (meth)acrylate structure which contains an alicyclic group, from a material having a structure containing esters of acrylic acid which comprise in the ester group a unit having a high polarity, or from a material having a (meth)acrylate structure which contains in the ester group a unit having a high polarity, their base polymer has a high polarity and thus, a high hydrophobicity can be neutralised due to the alicyclic group.

As a result, a difference in polarity is caused between the hydrocarbon-type protective layer and the resist. Therefore, the resist layer is no longer dissolved and a protective layer can be coated on the resist. Consequently, it is possible to form a pattern having a desired size.

### [2]The resin (IIA) which constitutes the radioactive-rays sensitive material (II) of the present invention and the starting materials thereof will now be explained.

### Resin (IIA)

The resin (IIA) which contains in the molecule at least one unsaturated group and at least one functional group capable of producing an alkali-soluble group under the action of an acid may be simply synthesised by copolymerising a polymerisable monomer (D) which contains a functional group capable of producing an alkali-soluble group under the action of an acid (as explained in the item of resin (IA)) and a polymerisable monomer (E) which contains an acid group or an epoxy group to obtain a copolymer (F) as shown in Formula (3) (partially shown in the Formula) and then by adding to the copolymer (F) a monomer (G) containing an unsaturated group as shown in Formula (4). 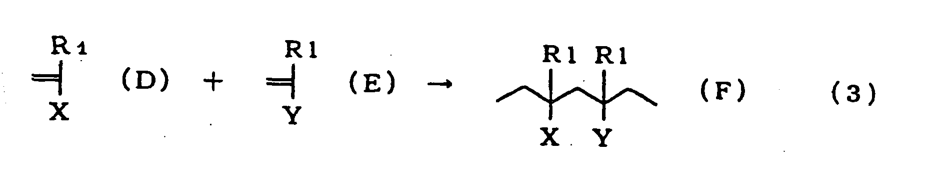 wherein R1 is a hydrogen or CH₃, X is the functional group which produces an alkali-soluble group under the action of an acid, Y is an acid group or an epoxy group 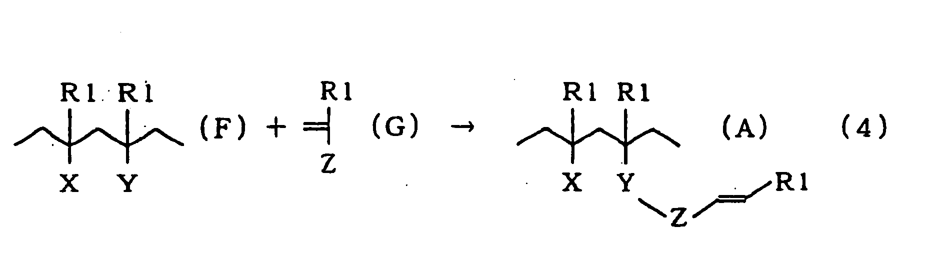 wherein R1 is a H or CH₃, X is the functional group which produces an alkali-soluble group under the action of an acid, Y is, in Formula (F), an acid group or an epoxy group, Z is, in Formula (G), an epoxy group when Y is an acid group, and an acid group when Y is an epoxy group, Y and Z are, in Formula (A), the reacted forms of Y and Z respectively.

The resin (IIA) may also contain a radically polymerisable monomer (H) having an unsaturated group.
Each monomer will now be further described
Monomer (D) is already explained in the item of resin (IA).

### Monomer (E)

The polymerisable monomer (E) containing an acid group or an epoxy group may contain a polymerisable monomer (E1) which contains an acid group. As a polymerisable monomer (E1), acrylic acid, methacrylic acid and the following modified unsaturated monocarboxylic acid (R) which are chain-extended between an unsaturated group and a carboxylic group or compounds that contain in the molecule at least two carboxylic groups such as maleic acid, may be used.

These compounds may be used alone or mixed together.

The modified unsaturated monocarboxylic acid (R) can specifically be used and, for examples,β-carboxyethyl(meth)acrylate, 2-(meth)acryloyloxyethylsuccinic acid, 2-(meth)acryloyloxyethylphthalic acid, 2-(meth)acryloyloxyethylhexahydrophthalic acid, unsaturated monocarboxylic acids which contain a lactone-modified ester bond or other ester bond and modified unsaturated monocarboxylic acids containing an ether bond may be used.

In the above-mentioned compounds (R), modified unsaturated monocarboxylic acid having an unsaturated group and a carboxylic group which are bound by a chain as shown in (i), (ii) and (iii) may be used without limitation. (i)As shown in Formula (5), a (meth)acrylate modified by a lactone ; 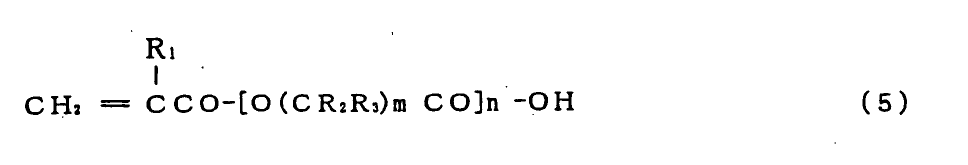 wherein R₁ is a hydrogen atom or a methyl group, R₂ and R₃ are hydrogen atoms, methyl groups or ethyl groups; m is an integer of 4-8; n is an integer of 1-10 ; several R₂ and R₃ groups may be identical or different from each other. (ii)As shown in Formula 6, a compound whose terminal hydroxyl group is modified by an acid anhydride ; 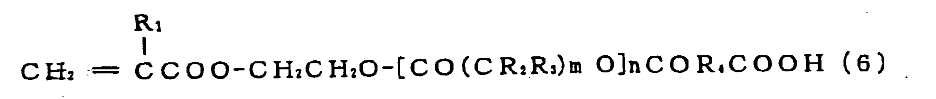 wherein R₁ is a hydrogen atom or a methyl group, R₂ and R₃ are hydrogen atoms, methyl groups or ethyl groups. R₄ is a divalent aliphatic saturated group having 1-10 carbons or a divalent saturated or unsaturated alicyclic hydrocarbon group having 3-6 carbons or a p-xylene group or phenylene group ; m is an integer of 4-8 ; n is an integer of 1-10 ; several R₂ and R₃ groups may be identical or different from each other.
(iii) as shown in Formula (7), a compound containing a terminal hydroxyl group having an ether bond which is modified by an acid anhydride compound ; 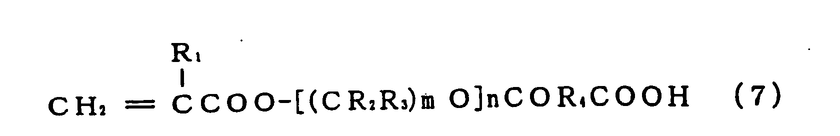 wherein R₁ is a hydrogen atom or a methyl group, R₂ and R₃ are hydrogen atoms, methyl groups, ethyl groups, propyl groups or butyl groups. R₄ is a divalent aliphatic saturated group having 1-10 carbons or a divalent saturated or unsaturated alicyclic hydrocarbon group having 3-6 carbons or a p-xylene group or phenylene group ; m is an integer of 4-8 ; n is an integer of 1-10 ; several R₂ and R₃ groups may be identical or different from each other.

The polymerisable monomer (E) which has an acid group or an epoxy group includes a polymerisable monomer (E2) containing an epoxy group. Any compound which contains, per molecule, one unsaturated radically polymerisable group and an epoxy group may be used as the monomer (E2). Specifically, compounds corresponding to the following Formulae (8), (8') and (8") may be used. 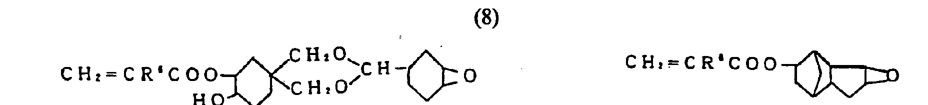 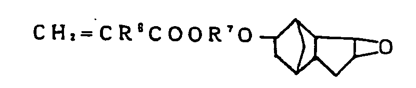 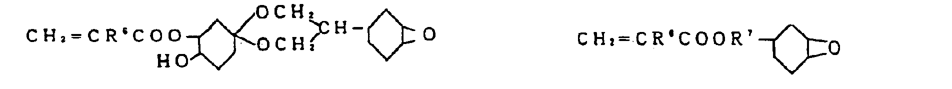 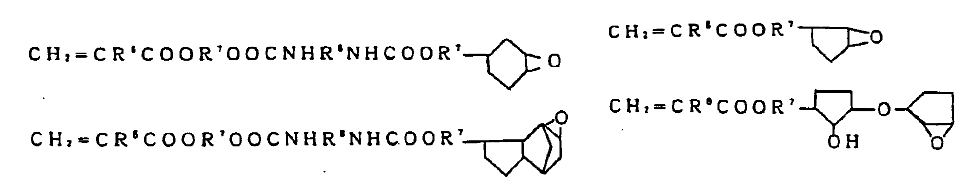 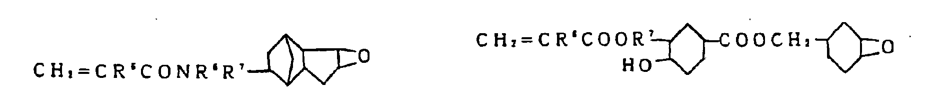 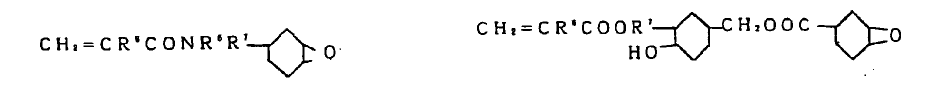 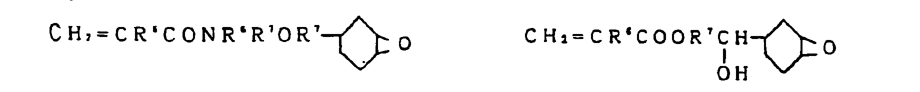 wherein each Formula, R⁶ is a hydrogen atom or a methyl group, R⁷ is a divalent-saturated aliphatic hydrocarbon group having 1-6 carbons, R⁸ is a divalent hydrocarbon group having 1-10 carbons and m is an integer of 1-10. 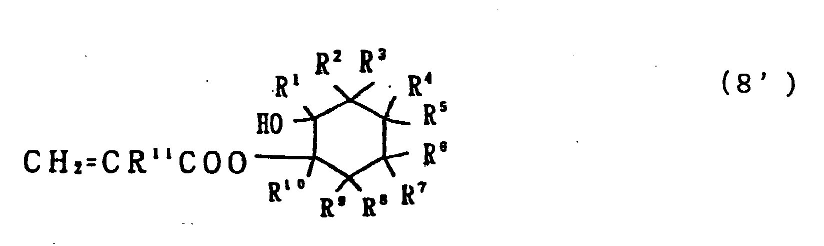 wherein R¹ to R¹⁰ are identical or different, hydrogen atoms, phenyl groups or alkyl groups having 1-8 carbons, one of R³, R⁴ and R⁶ is a 1, 2-epoxyethyl group or a 1-methyl-1, 2-epoxyethyl group, R¹¹ is a hydrogen atom, a methyl group or an ethyl group. 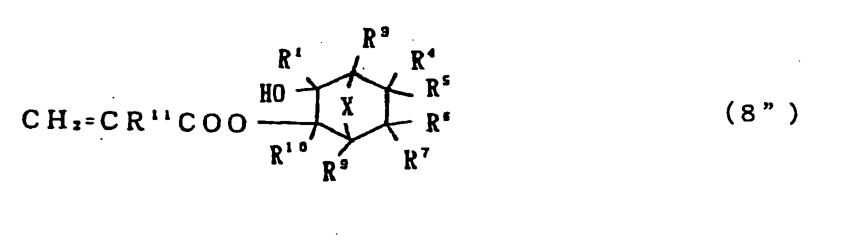 wherein R¹, R³-R⁷ and R⁸-R¹⁰ are identical or different, hydrogen atoms, phenyl groups, alkyl groups having 1-8 carbons, one of R³, R⁴ and R⁶ is a 1, 2-epoxyethyl group or a 1-methyl-1, 2-epoxyethyl group, R¹¹ is a hydrogen atom, a methyl group or an ethyl group, X is a methylene group.

However, in view of the dry-etching resistance, particularly, 3,4-epoxidized dicyclopentadiene-type monomer which has an alicyclic structure is preferably used.

The copolymer (F) is obtained by polymerising a mixture containing a monomer (D) in a molar ratio of 1 mole/ 1 mole.

The reaction may be carried out under a nitrogen atmosphere, the reaction temperature is in the range of -50-250°C.

Regarding the monomer (G)

As the monomer (G) to be added to the copolymer (F), when the polymer (F) is obtained by using a polymerisable monomer (E1) which contains an acid group, a monomer (G1) having a structure corresponding to (E2) is used. When the copolymer (F) is obtained by using a polymerisable monomer (E2) which contains an epoxy group, a monomer (G2) having a structure corresponding to (E1) is used.

The monomer (E1) and the monomer (G2) have the same structure, and the monomer (E2) and the monomer (G1) have the same structure.

The copolymer (A) is obtained by reacting a mixture of monomer (G) and copolymer (F) in a mole ratio of 1:1.

The reaction between the copolymer (F) and the monomer (G) is carried out under a nitrogen atmosphere and the reaction temperature is in the range of 60-140°C.

As a catalyst used for the addition reaction of the copolymer (F) and the monomer (G) (reaction of the epoxy group with the acid group), dimethylbenzylamine, triethylamine, tetramethyl ethylene diamine, tri-n-octylamine or other tertiary amines, tetramethylammonium chloride, tetramethylammonium bromide, tetrabutylammonium bromide or other quaternary ammonium salts, tetramethylurea or other alkyl urea compounds, tetramethylguanidine or other alkyl guanidine, triphenylphosphine or other phospine type compounds or salts thereof may be used. The above-mentioned catalysts may be used alone or mixed together.

These catalysts are employed at 0.01-10% by weight and preferably, 0.5-3.0% by weight based on the epoxy compound. When the amount of catalyst is less than 0.01 % by weight, the catalytic action is low, whilst when it is more than 10% by weight, the characteristics of the resin are damaged.

### Monomer (H)

When synthesising the resin (IIA), monomer (H) may be added to the monomers (D) and (E).

As the monomer (H) which contains an unsaturated group, it is possible to combine a radically polymerisable monomer (H1) which contains an unsaturated group and, if necessary, a radically polymerisable monomer (H2) containing an unsaturated group which contains an alicyclic functional group.

As the radically polymerisable monomer (H1) containing an unsaturated group, hydroxyethyl(meth)acrylate, hydroxypropyl(meth)acrylate, hydroxybutyl(meth)acrylate, polycaprolactonediolmono(meth)acrylate, polyoxyethyleneglycolmono(meth)acrylate or other hydroxyl group containing monomer (which are a part of the monomer (P) which contains a reactive unsaturated group as explained before), or the monomer (T) which contains an unsaturated group (as explained regarding the resin (IA)) may be used, for example.

As the radically polymerisable monomer (H2) containing an unsaturated group which contains an alicyclic functional group, a (meth)acrylate of an alcohol having an alicyclic functional group, particularly the monomer (C) which contains an alicyclic functional group containing a polar group (as explained in the item of the resin I) may be given as examples.

The amount of monomer (H) having an unsaturated group used is 0-80 mol% based on the monomer units contained in the produced resin.

In the reactions of Formulae (3) and (4), it is also possible to use a solvent.

Any compound that may dissolve the monomers (starting materials) and/or the copolymer may be used as a solvent without any limitation. For example, benzene, toluene, xylene or other aromatic hydrocarbon compounds, methanol, ethanol, 2-propanol or other alcohols, acetone, methyl ethyl ketone, methyl isobutyl ketone or other ketones, diethyl ether, dibutyl ether, dioxane or other ethers, ethyl acetate, isobutyl acetate, ethylene glycol monoacetate, propylene glycol monoacetate, dipropylene glycol monoacetate or other esters, ethylene glycol monoalkyl ethers, diethylene glycol monoalkyl ethers, propylene glycol monoalkyl ethers, dipropylene glycol monoalkyl ethers, butylene glycol monoalkyl ethers, ethylene glycol dialkyl ethers, diethylene glycol dimethyl ether, diethylene glycol diethyl ether or other diethylene glycol dialkyl ethers, ethylene glycol monoalkyl ether acetates, diethylene glycol monoalkyl ether acetates, dimethyl formamide, dimethyl acetamides or other amides, chloroform or other halogenated hydrocarbon compounds may be used. These solvents may be used alone or mixed together.

The amount of the solvents may be 30-10,000 parts by weight parts based on 100 weight parts of the resin.

For the purpose of improving the dry-etching resistance of the resist, it is possible to optionally add a monomer or an oligomer for dilution (hereinafter referred as diluted monomer (J) for dilution) to densify the crosslinking of the resin (IIA).

Compounds having a double bond which is radically polymerisable, such as, for example, acrylates, methacrylates, styrene or other vinyl-aromatic compounds, amide-type unsaturated compounds may be used as monomers (J) for dilution.

The following acrylates or methacrylates are typical. Methyl-(meth)acrylate, ethyl(meth)acrylate, isopropyl(meth)acrylate, n-butyl(meth)acrylate, pentyl(meth)acrylate, hexyl(meth)acrylate or other alkyl (meth)acrylates ; 2-hydroxyethyl(meth)acrylate, hydroxypropyl(meth)acrylate, hydroxybutyl(meth)acrylate, caprolactone-modified-2-hydroxyethyl(meth)acrylate or other (meth)acrylates containing a hydroxyl group, methoxydiethyleneglycol (meth)acrylate, ethoxydiethyleneglycol(meth)acrylate, isooctyloxydiethyleneglycol (meth)acrylate, phenoxytriethyleneglycol(meth)acrylate, methoxytriethyleneglycol (meth)acrylate, methoxypolyethyleneglycol#400-(meth)acrylate or other (meth)acrylates ; 1, 6-hexanedioldi(meth)acrylate, neopentylglycoldi(meth)acrylate or other bifunctional di(meth)acrylates, trimethylolpropanetri(meth)acrylate or other trifunctional (meth)acrylates may be used.

As the oligomer (a polymerisable prepolymer), for example, (meth)acrylates of polyester polyols, (meth)acrylates of polyether polyols, or resins containing hydroxy-(meth)acrylate introduced into polyols through polyisocyanates and additives of polyepoxides with (meth)acrylic acid may be used.

The above-mentioned monomer (J) for dilution is mixed in a desired amount, for example, 0-300 parts by weight and preferably 0-100 based on the amount of the resin (IIA). When the amount of the monomer (J) is more than 300 parts by weight, the features of the resin (IIA) are damaged.

### [3]Compound (B) capable ofproducing an acid under radioactive-rays irradiation

The compound (B) capable of producing an acid under radioactive-rays irradiation will now be explained.

It is possible to use the oxazole derivative shown in Formula (9), the s-triazine derivative shown in Formula (10), the iodonium salt shown in Formula (11), the sulphonium salt shown in Formula (12), the disulfone derivative shown in Formula (13), the imidosulphonate shown in Formula (14) or the diazonium salt shown in Formula (15) as a compound capable of producing an acid under radioactive-rays irradiation, which will be called an acid-generating agent. However, the agent is not limited to these examples. 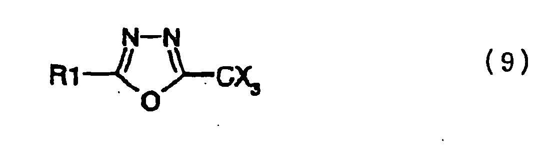 wherein R1 is a substituted or non-substituted alkyl group having 1-6 carbons, an alkenyl group having 1-6 carbons or an unsubstituted allyl group, X is Cl or Br. 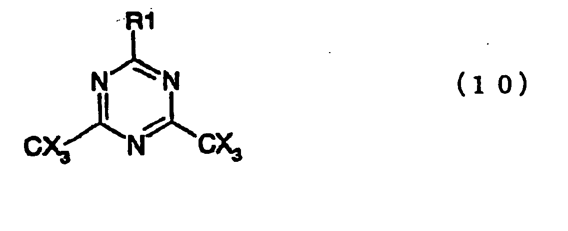 wherein R1 is a substituted or non substituted allyl group or an alkenyl group having 1-6 carbon atoms, X is Cl or Br; substituents are alkyl groups having 1-10 carbons, -NO_{2,} -OCH₃, -CHO 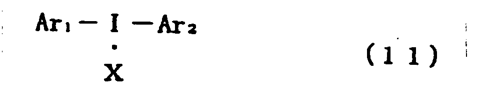 wherein Ar1 and Ar2 are substituted or non-substituted aromatic ring having 6-14 carbons, X is BF₆⁻, PF₆⁻, AsF₆⁻, SbF₆⁻, ClO₄⁻ or an anion of organic sulphonic acids. The substituents of Ar are alkyl-groups having 1-10 carbons, -NO_{2,} -OCH₃, -CHO. 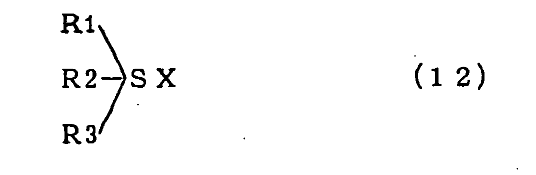 wherein R1, R2 and R3 are substituted or non-substituted alkyl groups having 1-20 carbons or aromatic rings of 6-14 carbons; X is BF₆⁻, PF₆⁻, AsF₆⁻, SbF₆⁻, ClO₆⁻ or an anion of sulphonic acids.

R₁ ―SO₂ ―SO₂ ―R₂ (13)

wherein R1 and R2 are substituted or non-substituted aromatic rings having 6-14 carbons or alicyclic groups. 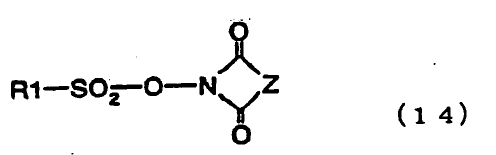 wherein R1 is a substituted or non-substituted alkyl group having 1-20 carbons or an allyl group; Z is a substituted or non-substituted alkylene group of 1-20 carbons, an alkenylene group or an allyl group.

Ar₁- N⁺₂ X⁻ (15)

wherein Ar1 is a substituted or non-substituted aromatic ring of 6-14 carbons; X is BF₆⁻, PF₆⁻, AsF₆⁻, SbF₆⁻, ClO₄⁻ or an anion of organic sulphonic acids.

### [4]Method for producing the radioactive-rays sensitive material and method for forming a pattern therewith

The production of a radioactive-rays sensitive material (resist) by using the above-mentioned resin (IA) and/or (IIA) [hereinafter referred to as resin (A) and distinguished from one another when necessary] and an acid-generating agent (B) will be explained hereinafter as well as the process of forming a resist layer on the base plate to be treated by using the resist obtained, irradiating it, developing it, dry etching it and removing the resist.

The production of the radioactive-rays sensitive material (resist) using the resin (A) and the acid-generating agent (B) consists of mixing 0.01-30 parts by weight of the acid-generating agent (B) based on 100 parts by weight of the resin (A), adding 100 parts by weight of this mixture into 50-10,000 parts by weight of solvent and mixing this mixture to form a homogenised resist solution. The order of adding the resin (A), the acid-generating agent (B) and the solvent may be suitably selected.

Solvents such as hexane, heptane, octane or other aliphatic hydrocarbons, toluene, xylene, or other aromatic hydrocarbons, mineral spirits or other hydrocarbons ; ethyl acetate, n-butyl acetate, isobutyl acetate, methyl lactate, ethyl lactate, methyl cellosolve acetate, butylcarbitol acetate or other ester type solvents ; methyl ethyl ketone, methyl isobutyl ketone, diisobutyl ketone, cyclohexanone or other ketone-like solvents ; ethanol, isopropanol, n-butanol, sec-butanol, isobutanol or other alcoholic solvents, n-butyl ether, dioxan, ethylene glycol monomethylether, ethylene glycol monoethylether, propylene glycol monomethylether, dipropylene glycol monomethyl ether or other ether type solvents may be used. These solvents may also be used in a suitable mixture.

The formation of the resist layer on the base plate to be treated consists of providing the resist solution obtained on the semiconductor thin layer which is coated by a protective layer while the base plate to be treated is turning in order to carry out a coating of a determined thickness according to the spin-coating method. The thickness of the resist layer is 0.1-10 µm.

The base plate which is coated with the resist (hereinafter referred to as the resist base plate) is pre-heated (prebaked) and selectively irradiated with an eximer laser or the like. An acid is then produced in the resist layer by the acid-generating agent (B) due to irradiation.

A laser having an output power of 0.01-100W or so and preferably 1-10 W may be used.

After irradiation, the resist base plate may optionally be heated for 0-60 minutes at 50-200°C and a low temperature-post bake is then carried out. The acid produced is like a catalyst and due to its presence in the resin (A), the reaction which transforms the group capable of producing an akali-soluble group into an alkali-soluble group occurs several times. Therefore, the resist is then transformed into an alkali-soluble material.

A process for improving a chemical amplification by using an acid produced by irradiation and a low temperature-post bake will now be described.

After the low temperature-post bake, the resist base plate is developed by using an alkali solution. Further, it is possible to form a microscopic pattern in a stable manner by carrying out a high temperature post bake or the like.

Moreover, this high temperature post bake which is carried out after developing, shows a process for promoting the crosslinking reaction of the unsaturated groups in the resin. When the temperature of the high temperature-post bake is not less than 120°C, the crosslinking reaction of the resin which is thermally polymerised is promoted.

When the resin (IIA) is used, it is possible to use a radical initiator (polymerisation initiator for crosslinking) which produces radicals to promote the crosslinking reaction during the high temperature post bake and to improve the dry-etching resistance. Any compound which shows a half period-temperature of not less than 50°C may be used as such an initiator. Di-t-butyl peroxide, t-butyl peroxyisopropyl carbonate, 1, 1'-azobis(cyclohexane-1-carbonitrile) or the like may be given as examples.

When the resin (IA) is used, it is necessary to improve the developing solution in order to obtain more stable patterning features. Due to the pollution by the amines or the like in the environment, the protonic acid is inactivated in the surface portion of the chemically amplified-resist. As a result, the specific problem is that the resin (IA) is hard to dissolve in the developing solution. For this reason the principal factor is that there is a difference between the solubility of the internal portion of the resist and the solubility of the surface portion of the resist and therefore it is difficult to form a stable pattern.

Particularly, it is known that in groups having a high hydrophobicity such as an adamantyl group or a t-butyl group or the like which are hydrocarbon groups, there is an effect which prevents the dissolution in the developing solution and the influence to the non-solubility in the surface portion is important. For this reason, in the present invention where a polar group has been introduced into an adamantyl group or the like, the above-mentioned point is largely improved. However, it is also necessary to improve the developing solution to obtain excellent patterning features.

Consequently, due to the use of a mixture of an aqueous solution of an organic alkali compound such as tetramethyl(ethyl, propyl) ammonium hydroxide, and isopropyl alcohol or the above-mentioned ether type solvents, particularly ethylene glycol monomethyl ether, ethylene glycol monoethyl ether, propylene glycol monomethyl ether, dipropylene glycol monomethyl ether or other glycol ether-type solvents in the developing solution, the solubility of the resist is increased, and the difference of solubility between the surface portion and the internal portion is lowered. Thus, it is possible to obtain a stable pattern. Further, as an alcohol to be added, isopropyl alcohol is the most efficient. In the case of methanol or ethanol, some cracks appear and a peeling off is noticed. Moreover, when using this developing solution mixture, the sensitivity is increased in at least one unit and the deformations due to developing are also decreased.

Moreover, this developing solution contains preferably 5-95 vol% of isopropyl alcohol or the above-mentioned ether-type solvents. When it contains less than 5 vol%, the sensitivity is not increased. When it contains more than 95 vol%, cracks and fissures tend to appear.

In the present invention, the organic alkali compound is for example tetramethyl(ethyl, propyl)ammonium hydroxide which is commercially supplied as an aqueous solution of 2.3-2.5%. This aqueous solution is employed in a mixture with the above-mentioned organic solvent such as isopropyl alcohol.

Further, according to the present invention, it is possible to coat on a resist a hydrocarbon-type polymer as a protective layer, even in the case of a resin containing highly hydrophobic hydrocarbon groups for increasing the polarity of the base polymer like a resist containing itaconic anhydride which has a high polarity. This was impossible in the prior art. Due to the protective layer formed on the resist, it is possible to prevent the post-exposure delay (PED) which is a specific problem in the chemically amplified-type resists.

It is possible to apply the protective layer in a more sure way, when using a hydrocarbon-type solvents having a high molecular weight, as a solvent for applying the protective layer. As the solvent for applying, any compound having a boiling point of not less than 10°C is preferably used. In the case of a solvent having a very low boiling point, it is difficult to homogeneously coat the protective layer on an Si wafer.

For this reason, specifically, limonene, 1, 5-dicyclooctadiene, 1-decene, t-butylcyclohexane, p-cymene, dodecylbenzene or the like may be given as examples of applying solvents, but solvents that may be used are not limited to these examples.

Polyolefins, polydienes or the like may be given as examples of the hydrocarbon polymers used to form the protective layer on the resist base plate. However, any polymer which can be dissolved in the above-mentioned solvents and which is transparent to the irradiation wavelength may be used without any limitation.

After developing, the resist base plate is dry-etched.

The dry-etching method used may be, for example, the plasma etching, the reactive-ion etching, the ion milling or the like.

After dry etching, the remaining resist and the protective layer are removed from the resist base plate with a solvent.

There are several moist or dry methods to remove the remaining resist and the protective layer. The oxygen plasma-etching may be given as a dry-method example. Method using organic solutions containing phenol and a halogenated solvent as a main component, and methods using inorganic solutions such as sulphuric acid/hydrogen peroxide, hydrofluoric acid, hydrochloric acid/hydrogen peroxide may given as examples of moist methods.

The semiconductor having the resulting pattern may be used for a memory having a capacity of several Mega bytes to several Giga bytes.

### EXAMPLES

The invention will be illustrated more specifically by the following Examples but the invention is not limited thereto.

In each of the following Examples and Comparative Examples, the common part will be explained. When some parts are different from this pattern, they will be explained more specifically.

The apparatus used contains a stirrer, a thermometer, a condenser, a dropping funnel and a nitogen inlet tube which are provided on 2-litre separable flasks. After reaction, the resin (IA) and the resin (IIA) are purified by precipitation with methanol and pure water, respectively.

After purification, 15wt% of triphenylsulphonium hexafluoroantimony which is an acid-generating agent having the structure as shown in Formula (12') was added to form a solution containing 50% by weight of cyclohexanone.

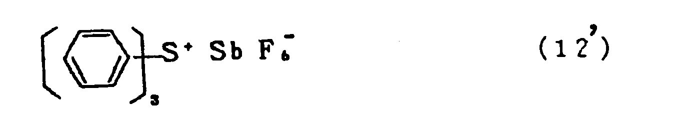

This solution was coated by the spin coating method on an Si wafer covered with a novolak resin which has been hard baked to form a 0.7µm layer. A prebake was then carried out at 60°C for 10s econds on a hot plate. The resist layer which is then obtained on the wafer was then exposed to light with a KrF eximer stepper having an irradiating dose of 100mJ/cm2. Then a PEB was then carried out at a temperature of 100°C for 60 seconds.

The resulting plate was then succesively developed for 60 seconds using an alkaline aqueous solution as a developing solution and rinsed with pure water over 30 seconds.

In each of the following Examples and Comparative Examples, the chemically amplifying treatment is abbreviated as a low temperature PEB, the post bake treatment is abbreviated as a high temperature PEB and the oxygen plasma-etching treatment is abbreviated as an O₂ RIE.

The line width of the pattern is abbreviated as an L&S (line and space).

ABN-E is 2, 2'-azobis(2-methyl-butyl nitrile) (manufactured by Nippon Hydrazin Industries, Ltd.)

Cyclomer A200 is 3, 4-epoxy-cyclohexyl methyl acrylate (manufactured by Daicel Chemical Industries, Ltd.)

MMPG is propylene glycol monomethyl ether (manufactured by Daicel Chemical Industries, Ltd.)

NMD-3 is the developing solution (manufactured by NMD-3 Tokyoohka, Ltd.).

First, the radioactive-rays sensitive material (I) and the pattern-forming method using this material will be described.

The ratio of monmer (C) with respect to monomer (D) in the resulting resin (A) is in moles.

### Example I-1

0.25 litre of toluene was introduced into the reaction apparatus and heated to 100°C. Then 222g of monohydroxyadamantyl acrylate, 142g of t-butyl-methacrylate, 30.3g of ABN-E and 120g of toluene were added dropwise together over 3 hours. After dropwise addition, the mixture was left for 4 hours and then purified. The resulting resin had the structure shown in Formula (16).

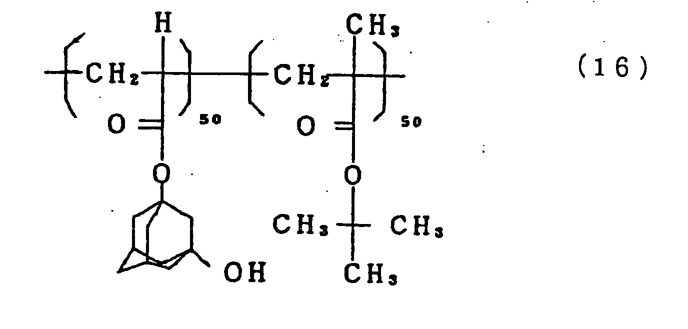

The copolymer obtained had a ratio of monohydroxyadamantyl acrylate / t-butylmethacrylate of 50:50, a weight-average molecular weight of 5,400 and a molecular weight distribution of 1.9.

An acid-generating agent was then added to the synthesised polymer to form a solution.

This solution was then coated on an Si wafer according to the spin coating method. The resist layer obtained on the wafer after a prebaking was then irradiated and submitted to a low temperature PEB. The resulting plate was then succesively developed using NMD-3 and rinsed.

The semiconductor obtained showed a pattern of an L&S having a width of 0.50µm.

### Example I-2

0.25 litre of toluene was introduced into the reaction apparatus and heated to 100°C. Then 254g of trihydroxyadamantyl acrylate, 142g of t-butylmethacrylate, 30.3g of ABN-E and 120g of toluene were added dropwise together over 3 hours. After dropwise addition, the mixture was left for 4 hours and then purified. The resulting resin had the structure shown in Formula (17).

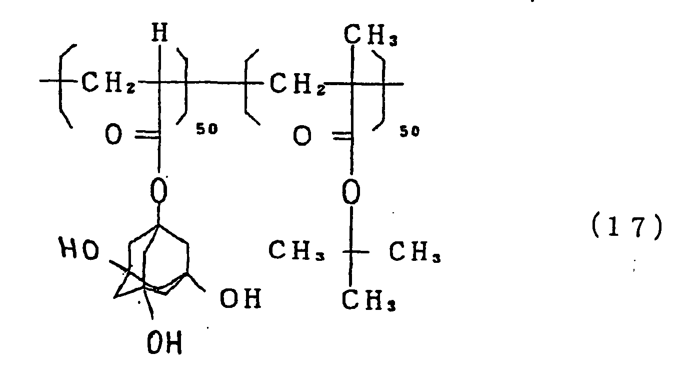

The copolymer obtained had a ratio of trihydroxyadamantyl acrylate / t-butylmethacrylate of 50:50, a weight-average molecular weight of 5,200 and a molecular weight distribution of 1.9.

An acid-generating agent was then added to the synthesised polymer to make a solution.

This solution was then coated on an Si wafer according to the spin coating method. The resist layer obtained on the wafer after a prebaking was irradiated and then submitted to a low temperature PEB. The resulting plate was then succesively developed using NMD-3 and rinsed.

The semiconductor obtained showed a pattern of an L&S having a width of 0.52µm.

### Example I-3

0.25 litre of toluene was introduced into the reaction apparatus and heated to 100°C. Then 316g of trihydroxyadamantyl methacrylate, 116g of t-butyl-methacrylate, 120g of toluene and 30.3g of ABN-E were added dropwise together for 3 hours. After dropwise addition, the mixture was left for 4 hours and then purified. The resulting resin had the structure shown in Formula (18). 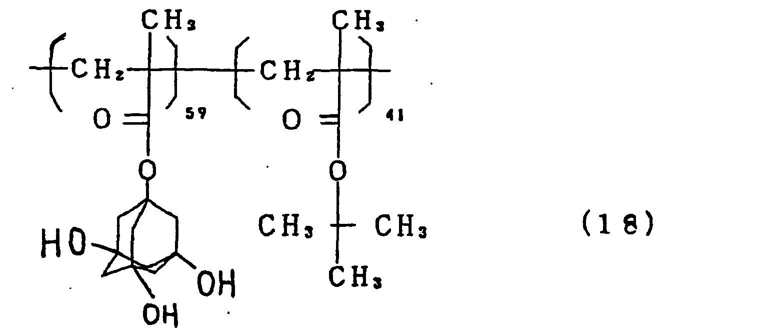 The copolymer obtained had a ratio of trihydroxyadamantyl methacrylate / t-butyl-methacrylate of 59:41, a weight-average molecular weight of 5,500 and a molecular weight distribution of 1.9.

An acid-generating agent was then added to the synthesised polymer to make a solution.

This solution was then coated on an Si wafer according to the spin coating method. The resist layer obtained on the wafer was irradiated after a prebaking and then submitted to a low temperature PEB. The resulting plate was then succesively developed using NMD-3 and rinsed.

The semiconductor obtained showed a pattern of an L&S having a width of 0.55µm.

### Example I-4

A mixture (1:1 by weight) of NMD-3 and isopropyl alcohol was used as a developing solution instead of the NMD-3. The other operations were carried out as described in Example I-3.

The semiconductor obtained showed a pattern of an L&S having a width of 0.45µm.

### Example I-5

0.25 litre of toluene was introduced into the reaction apparatus and heated to 100°C. Then 214.4g of trihydroxyadamantyl methacrylate, 273.6g of di-t-butyl fumarate, 120g of toluene and 30.3g of ABN-E were added dropwise together over 3 hours. After dropwise addition, the mixture was left for 4 hours and then purified. The resulting resin had the structure shown in Formula (19). 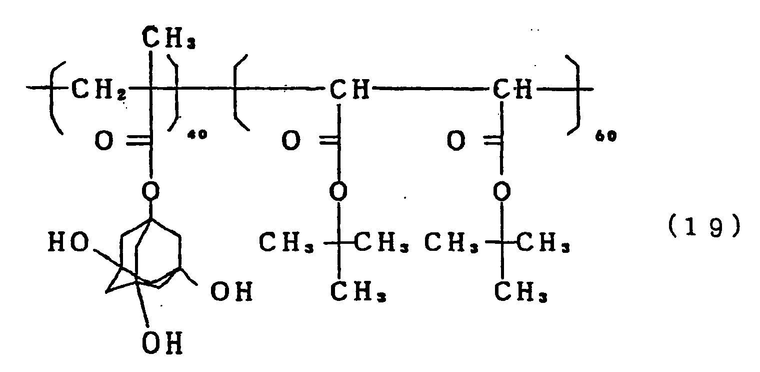 The copolymer obtained had a ratio of trihydroxyadamantyl methacrylate / di-t-butyl fumarate of 40:60, a weight-average molecular weight of 8,500 and a molecular molecular weight distribution of 2.3.

An acid-generating agent is then added to the synthesised polymer to form a solution.

This solution is then coated on an Si wafer according to the spin coating method. The resist layer obtained on the wafer was then irradiated after a prebaking and submitted to a low temperature PEB. The resulting plate was then succesively developed with NMD-3 and rinsed.

The semiconductor obtained showed a pattern of an L&S having a width of 0.60µm.

### Comparative Example I-1

0.25 litre of toluene was introduced into the reaction apparatus and heated to 100°C. Then 260g of adamantylmethacrylate, 116.4g of t-butyl methacrylate, 30.3g of ABN-E and 120g of toluene were added dropwise together over 3 hours. After dropwise addition, the mixture was left for 4 hours and then purified. The resulting resin had the structure shown in Formula (20). 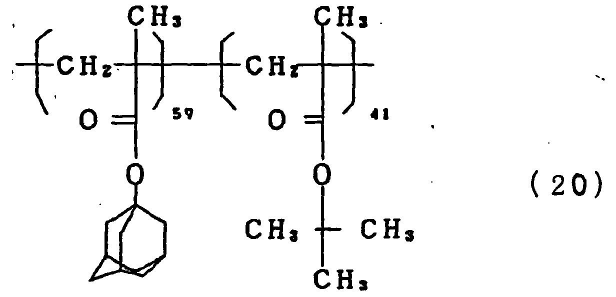 The copolymer obtained had a ratio of adamantylmethacrylate / t-butyl-methacrylate of 59:41, a weight-average molecular weight of 5,500 and a molecular weight distribution of 1.9.

An acid-generating agent was then added to the synthesised polymer to make a solution.

This solution was then coated on an Si wafer by the spin coating method. The resist layer which was obtained on the wafer was then irradiated after a prebaking and submitted to a low temperature PEB. The resulting plate was then succesively developed with NMD-3 but the developing did not progress, and a pattern could not be obtained.

### Comparative Example I-2

A mixture (1:1 by weight) of NMD-3 and isopropyl alcohol (1:1) was used instead of the NMD-3 which was used as a developing solution in Comparative Example I-1. The other operations were similar to Comparative Example I-1. The pattern obtained showed an L&S having a 0.50 µm width but has no reproducibility.

### Example I-6

A resist layer having a thickness of 0.6µm was coated on an Si wafer. The resulting plate was then heated (baked) at 60°C on a hot plate for 20 minutes. As in Example I-3, the plate was then irradiated and submitted to a low temperature PEB treatment and developed. The resulting semiconductor showed a pattern having an L&S of a 0.5512µm width.

### Comparative Example I-3

The operations were similar to those of Comparative Example I-1 except that the plate was baked at 60°C on a hot plate for 20 minutes. It was then difficult to form a resist layer having a homogeneous thickness. With only this bake treatment, the hydroxyl groups remain on the Si wafer and thus, repelling and coating irregularities appear. By a HMDS treatment (hexamethyl disilazane) of the hydroxyl groups which remain in the Si wafer, it is possible to obtain a resist layer of a determined thickness. A post treatment of the resist which shows a low adhesion is thus necessary.

The above experiments show that it is possible to obtain a stable pattern and to improve the adhesion in an extraordinary way even when the proportion of adamantyl groups which have a high polarity was increased for improving the dry-etching resistance.

By the present invention, it is now possible to obtain a stable specific pattern having not only a high transparency and a high dry-etching resistance but also an excellent adhesion and a high sensitivity. Therefore, it is possible to produce submicroscopic semiconductors. The first aim of the present invention was then reached.

The radioactive-rays sensitive material (II) an a method for producing a pattern thereof will now be described.

The ratio of the resulting resin (IIA) 1: m:n is given by mole.

### Example II-1

390g of MMPG were introduced into the reaction apparatus and heated to 110°C. Then 78g of methacrylic acid, 446g of t-butyl methacrylate, 220g of methylmethacrylate and 24g of ABN-E were added dropwise together into the apparatus over 3 hours. After dropwise addition, the reaction mixture was left for 4 hours to synthesise a main polymer containing carboxyl groups. 166g of cyclomer A200, 4g of triphenylphosphine and 1.3g of methylhydroquinone were then added to the main polymer solution and reacted at 100°C for 10 hours. A purification by precipitation was then carried out. The resin obtained had the structure shown in Formula (21) described below, a ratio of 1: m : n = 50:35:15, a weight-average molecular weight of 6,000 and a molecular weight distribution of 2.1.

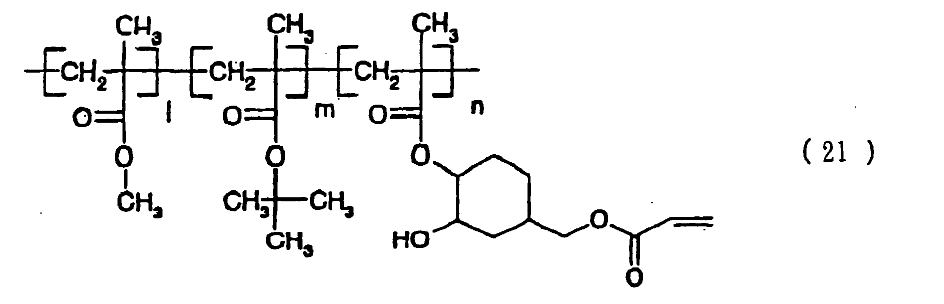

An acid-generating agent was then added to the resulting polymer to form a solution.

An Si wafer was then coated with this solution according to the spin coating method and prebaked to form a resist layer on a wafer. This resist layer was then irradiated and submitted to a low temperature PEB.

This wafer was then developed with NMD-3 and submitted to a high temperature PEB treatment for 2 hours at 150°C to crosslink the acrylic groups. The pattern obtained showed an L&S of 0.7µm width. It was then possible to copy the pattern on a 1.9µm depth by using a mask and O₂Ri treatment on the resulting resist pattern to etch the novolak type resist.

### Example II-2

390g of MMPG were introduced into the reaction apparatus and heated to 110°C. Then 78g of methacrylic acid, 339g of t-butylmethacrylate, 327g of adamantylmethacrylate and 24g of ABN-E were added dropwise together into the apparatus over 3 hours. After dropwise addition, the reaction mixture was left for 4 hours to synthesise a main polymer containing carboxyl groups. 166g of cyclomer A200, 4g of triphenylphosphine and 1.3g of methylhydroquinone were then added to the main polymer solution and reacted at 100°C for 10 hours. A purification by precipitation was then carried out. The resin obtained had the structure shown in Formula (22) described below, a ratio of 1: m : n = 50:31:19, a weight-average molecular weight of 5400 and a molecular weight distribution of 2.1.

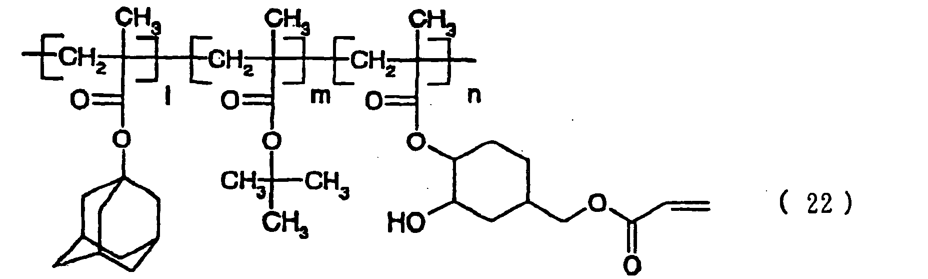

An acid-generating agent was then added to the polymers obtained to form a solution.

An Si wafer was then coated with this solution according to the spin coating method and prebaked to form a resist layer on a wafer. This resist layer was then irradiated and submitted to a low temperature-PEB.

This wafer was then developed with NMD-3 and submitted to a high temperature PEB treatment for 2 hours at 150°C to crosslink the acrylic groups. The pattern obtained showed an L&S of 0.50µm width. It was then possible to copy the pattern on a 2.2µm depth by using a mask and O₂Ri treatment on the resist pattern obtained to etch the novolak type resist.

### Example II-3

390g of MMPG were introduced into the reaction apparatus and heated to 110°C. Then 66g of acrylic acid, 346g of t-butylmethacrylate, 333g of monohydroxyadamantyl methacrylate and 24g of ABN-E were added dropwise together therein over 3 hours. After dropwise addition, the reaction mixture was left for 4 hours to synthesise a main polymer containing carboxyl groups. 166g of cyclomer A200, 4g of triphenylphosphine and 1.3g of methyl-hydroquinone were then added to the main polymer solution and reacted at 100°C for 10 hours. A purification by precipitation was then carried out. The resin obtained had the structure shown in Formula (23) described below, a ratio of 1: m : n = 50:31:19, a weight-average molecular weight of 5200 and a molecular-weight distribution of 2.1.

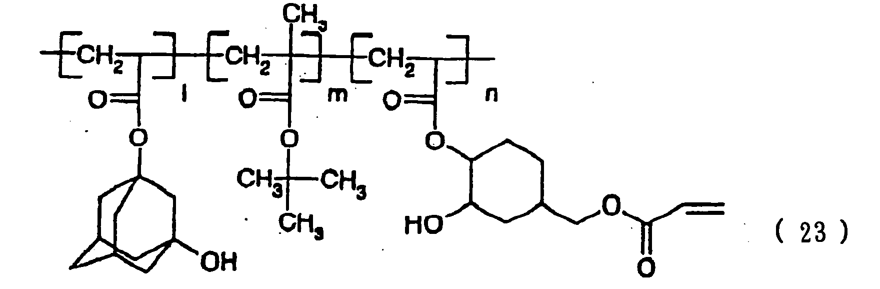

An acid-generating agent was then added to the polymer obtained to form a solution.

An Si wafer was then coated with this solution according to the spin coating method and prebaked to form a resist layer on a wafer. This resist layer was then irradiated and submitted to a low temperature-PEB.

This wafer was then developed with NMD-3 and submitted to a high temperature-PEB treatment for 2 hours at 150°C to crosslink the acrylic groups. The pattern obtained showed an L&S of 0.5µm width. It was then possible to copy the pattern on a 2.3µm depth by using a mask and O2Ri treatment on the resist pattern obtained to etch the novolak type resist.

### Exampe II-4

390g of MMPG were introduced into the reaction apparatus and heated to 110°C. Then 78g of methacrylic acid, 355g of t-butylmethacrylate, 347g of monohydroxyadamantyl acrylate and 24g of ABN-E were added dropwise together therein over 3 hours. After dropwise addition, the reaction mixture was left for 4 hours to synthesise a main polymer containing carboxyl groups. 129g of glycidylmethacrylate (Blenmer-G, manufactured by Nipponyushishasei), 4g of triphenylphosphine and 1.3g of methylhydroquinone were then added to the main polymer solution and reacted at 100°C for 10 hours. A purification by precipitation was then carried out. The resin obtained had the structure shown in Formula (24) described below, a ratio of 1:m:n= 50:32:18, a weight-average molecular weight of 6300 and a molecular-weight distribution of 2.1.

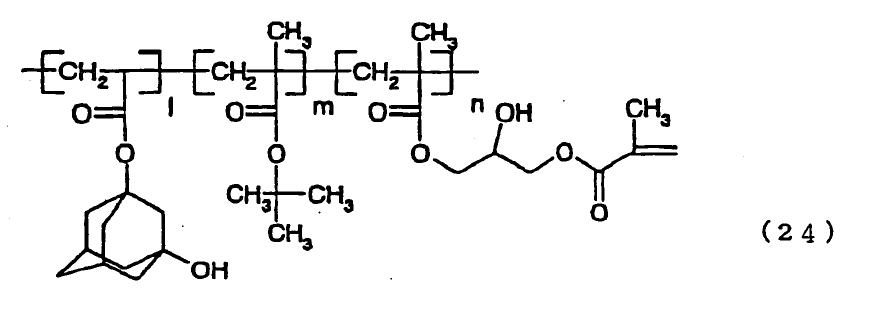

An acid-generating agent was then added to the polymer obtained to form a solution.

An Si wafer was then coated with this solution according to the spin coating method and prebaked to form a resist layer on a wafer. This resist layer was then irradiated and submitted to a low temperature PEB.

This wafer was then developed with NMD-3 and submitted to a high temperature-PEB treatment for 2 hours at 150°C to crosslink the acrylic groups. The pattern obtained showed an L&S of 0.9µm width. It was then possible to copy the pattern on a 2.0µm depth by using a mask and O2Ri treatment on the resist pattern obtained to etch the novolak type resist.

### Example II-5

The Example II-5 is similar to Example II-1 but instead of using a developing solution of NMD-3, a mixture of NMD-3 and isopropyl alcohol was used. The pattern obtained showed an L&S having a width of 0.45µm.

### Example II-6

390g of MMPG were introduced into the reaction apparatus and heated to 110°C. Then 78g of methacrylic acid, 421g of dibutyl fumarate, 244g of trihydroxyadamantyl methacrylate and 24g of ABN-E were added dropwise together into the apparatus over 3 hours. After dropwise addition, the reaction mixture was left for 4 hours to synthesise main polymer containing carboxyl groups. 166g of cyclomer A200, 4g of triphenylphosphine and 1.3g of methyl-hydroquinone were then added to the main polymer solution and reacted at 100°C for 10 hours. A purification by precipitation was then carried out. The resin obtained had the structure shown in Formula (25) described below, a ratio of 1:m:n= 50:25:25, a weight-average molecular weight of 5400 and a molecular-weight distribution of 2.1.

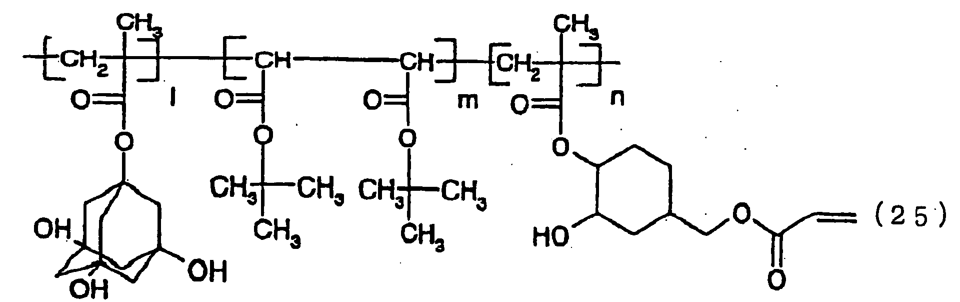

An acid-generating agent was then added to the polymers obtained to form a solution.

An Si wafer was then coated with this solution according to the spin coating method and prebaked to form a resist layer on a wafer. This resist layer was then irradiated and submitted to a low temperature-PEB.

This wafer was then developed with NMD-3 and submitted to a high temperature-PEB treatment for 2 hours at 150°C to crosslink the acrylic groups. The pattern obtained showed an L&S of 0.50µm width. It was then possible to copy the pattern on a 2.3µm depth by using a mask and O₂Ri treatment on the resist pattern obtained to etch the novolak type resist.

### Example II-7

Based on 100 parts by weight of the resin, 30 parts by weight of dipentaerythritol hexacrylate were added in the photo-sensitive solution of the resist obtained in Example II-1. The pattern showed by irradiation an L&S of 0.80µm. It was then possible to copy the pattern on a 2.3µm depth by using mask and O2Ri treatment on the resist pattern obtained to etch the novolak type resist.

### Comparative Example II-1

390g of toluene were introduced into the reaction apparatus and heated to 110°C. Then 534g of t-butyl methacrylate, 376g of methyl-methacrylate and 24g of ABN-E were added dropwise together therein over 3 hours. After dropwise addition, the reaction mixture was left for 4 hours. A purification by precipitation with methanol was then carried out. The resin obtained had the structure shown in Formula (26) described below, a ratio of 1:m = 50:50, a weight-average molecular weight of 5000 and a molecular-weight distribution of 2.1.

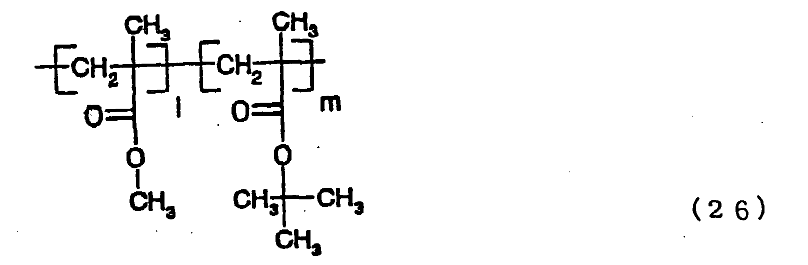

An acid-generating agent was then added to the polymers obtained to form a solution.

An Si wafer was then coated with this solution according to the spin coating method and prebaked to form a resist layer on a wafer. This resist layer was then irradiated and submitted to a low temperature PEB.

This wafer was then developed with NMD-3 and submitted to a high temperature PEB treatment for 2 hours at 150°C to crosslink the acrylic groups. The pattern obtained showed an L&S of 0.70µm width. It was not possible to copy the pattern by using a mask and O2Ri treatment on the resulting resist pattern to etch the novolak type resist.

From the basis of these results, it is proved that the dry-etching resistance may be improved by chain reactive vinyl groups in side chains. Further, it was also proved that the partial introduction of a unit containing an adamantyl group greatly improves the dry-etching resistance. The present invention enables a stable and specific pattern to be obtained.

By the present invention, it is now possible to obtain a stable specific pattern having not only a high transparency and a high dry-etching resistance but also an excellent adhesion and a high sensitivity. It is possible therefore to produce submicroscopic semiconductors. The second aim of the present invention was then reached.

## Claims

1. A method of producing a resin (A) for a radiation-sensitive material having at least one alicyclic functional group containing a polar group and at least one functional group which can produce an alkali-soluble group by an acid, **characterized in that** a monomer (C) having an alicyclic functional group containing a polar group, a monomer (D) having a functional group which can produce an alkali-soluble group, and a polymerization initiator or a catalyst are added to a solvent which is heated to a polymerization temperature, followed by being copolymerized.

2. The method of producing a resin (A) for a radiation-sensitive material as claimed in claim 1, wherein the polar group in the monomer (C) is a group derived from a ketone, an alcohol, an ether, an ester, a carboxylic acid, an acid anhydride, or a group having a structure in which atoms in the group derived are partially substituted by sulfur, nitrogen, or a halogen.

3. The method of producing a resin (A) for a radiation-sensitive material as claimed in claim 1 or 2, wherein the alicyclic functional group in the monomer (C) is a norbornyl group, cyclohexyl group, tricyclodecanyl group, or adamantyl group.

4. The method of producing a resin (A) for a radiation-sensitive material as claimed in any one of claims 1 to 3, wherein the polar group in the monomer (C) is a group derived from a ketone, an alcohol, an ether, an ester, a carboxylic acid, an acid anhydride, or a group having a structure in which atoms in the group derived are partially substituted by sulfur, nitrogen, or a halogen, and the alicyclic functional group in the monomer (C) is a norbornyl group, cyclohexyl group, tricycloclecanyl group, or adamantyl group.

5. The method of producing a resin (A) for a radiation-sensitive material as claimed in any one of claims 1 to 4, wherein the resin (A) is a (meth)acrylic resin.

6. A resin (A), **characterised in that** it is obtainable by a method according to any one of claims 1 to 5.

7. Use of a resin (A) according to any one of claims 1 to 6 for the preparation of a radiation-sensitive material.
